# EUROPÄISCHE PATENTANMELDUNG

(11) **EP 3 490 076 A1**
(43) Veröffentlichungstag der Anmeldung: **29.05.2019**
(21) Anmeldenummer: 18204230.9
(22) Anmeldetag: 05.11.2018
(51) Int. Cl.: H01R 12/51, H01R 12/71, H01R 13/66, H05K 7/00, H01R 9/24

(54) **MODULARER STECKVERBINDER**

(30) Priorität: 27.11.2017 BE 201705861
(71) Anmelder: Phoenix Contact GmbH & Co. KG, 32825 Blomberg (DE)
(72) Erfinder: WERNER, Ingo, 32670 Detmold (DE); FRIEDRICH, Thorsten, 31855 Aerzen (DE); BATH, Klaus-Michael, 32825 Blomberg (DE); SCHRADER, Andreas, 33129 Delbrück (DE)
(74) Vertreter: Richly & Ritschel Patentanwälte PartG mbB

(57) **Zusammenfassung**

Die vorliegende Erfindung offenbart einen modularen Steckverbinder (1, 2), die folgenden Merkmale aufweisend:
- der modulare Steckverbinder (1, 2) weist zumindest eine Anschlussklemme (10) und ein Leiterplattenmodulgehäuse (20) auf, das mit der Anschlussklemme (10) verbunden ist;
- das Leiterplattenmodulgehäuse (20) weist eine Aufnahme (21) zum reversiblen Einsetzen einer Modul-Leiterplatte (30) auf;
- das Leiterplattenmodulgehäuse (20) weist einen Spannungseingangsanschluss (26) zur Verbindung mit einer Spannungsquelle und eine mit dem Spannungseingangsanschluss (26) elektrisch verbundene Spannungsversorgungskontaktierung (27) auf;
- eine in der Aufnahme (21) eingesetzte Modul-Leiterplatte (30) ist mittels der Spannungsversorgungskontaktierung (27) durch den Spannungseingangsanschluss (26) mit elektrischer Energie versorgbar; und
- das Leiterplattenmodulgehäuse (20) weist einen Signalleitungsanschluss (28) und eine mit dem Signalleitungsanschluss (28) elektrisch verbundene Signalleitungskontaktierung (29) auf, so dass ein Datenaustausch zwischen dem Signalleitungsanschluss (28) und der in die Aufnahme eingesetzte Modul-Leiterplatte (30) über die Signalleitungskontaktierung (29) ermöglicht ist.

## Beschreibung

Die vorliegende Erfindung betrifft einen Steckverbinder mit einer austauschbaren Modul-Leiterplatte.

Elektrische Steckverbinder dienen zum Anschließen von elektrischen Leitern an beispielsweise eine Leiterplatte. Je nach Ausführungsform kann der elektrische Steckverbinder dabei als Buchsenteil oder als Steckerteil ausgebildet sein. Bei den einfachsten Ausführungen von Steckverbindern dienen diese lediglich zum Übertragen von elektrischer Leistung oder zum Übertragen von Daten und Signalen.

Ferner sind elektrische Steckverbinder bekannt, die mit einer Verarbeitungselektronik ausgestattet sind, die insbesondere auf einer Leiterplatte des Steckverbinders implementiert ist. Mittels der Verarbeitungselektronik können Signale und Daten verarbeitet und weitergeleitet werden. Zu diesen Daten bzw. Signalen können beispielsweise eine an einer Anschlussklemme des Steckverbinders anliegenden elektrischen Spannung, ein durch die Anschlussklemme fließender elektrischer Strom oder eine Temperatur der Anschlussklemme gehören.

Wenn sich die Anforderungen hinsichtlich der Verarbeitungselektronik des Steckverbinders ändern, müssen die aus dem Stand der Technik bekannten Steckverbinder in Gänze ausgetauscht werden, was einen erhöhten Materialaufwand und einen erheblichen Arbeitsaufwand für eine Neuverkabelung zur Folge hat.

Der vorliegenden Erfindung liegt die Aufgabe zugrunde, einen Steckverbinder bereitzustellen, der eine an unterschiedliche Bedürfnisse anpassbare Funktionalität aufweist.

Die der vorliegenden Erfindung zugrundeliegende Aufgabe wird durch einen modularen Steckverbinder mit den Merkmalen des Anspruchs 1 gelöst. Vorteilhafte Ausgestaltungen des Steckverbinders sind in den abhängigen Ansprüchen beschrieben.

Im Genaueren wird die der vorliegenden Erfindung zugrundeliegende Aufgabe durch einen modularen Steckverbinder gelöst, der zumindest eine Anschlussklemme und ein Leiterplattenmodulgehäuse aufweist, das mit der Anschlussklemme verbunden ist. Der modulare Steckverbinder ist als modularer elektrischer Steckverbinder ausgebildet. Das Leiterplattenmodulgehäuse weist dabei eine Aufnahme zum reversiblen Einsetzen einer Modul-Leiterplatte auf. Das Leiterplattenmodulgehäuse weist ferner einen Spannungseingangsanschluss zur Verbindung mit einer Spannungsquelle und eine mit dem Spannungseingangsanschluss elektrisch verbundene Spannungsversorgungskontaktierung auf. Eine in der Aufnahme eingesetzte Modul-Leiterplatte ist mittels der Spannungsversorgungskontaktierung durch den Spannungseingangsanschluss mit elektrischer Energie versorgbar. Weiterhin weist das Leiterplattenmodulgehäuse einen Signalleitungsanschluss und eine mit dem Signalleitungsanschluss elektrisch verbundene Signalleitungskontaktierung auf, so dass ein Datenaustausch zwischen dem Signalleitungsanschluss und der in die Aufnahme eingesetzte Modul-Leiterplatte über die Signalleitungskontaktierung ermöglicht ist.

Der erfindungsgemäße modulare Steckverbinder weist den Vorteil auf, dass die Funktionalität des Steckverbinders durch Austausch der Modul-Leiterplatte auf einfache Art und Weise veränderbar ist. Somit muss bei einer Änderung an die Signalverarbeitungslogik nicht der gesamte Steckverbinder ausgewechselt werden, so dass keine erneute elektrische Verbindung des Steckverbinders mit beispielsweise einer Leiterplatte notwendig ist. Folglich ist erheblich weniger Arbeitsaufwand notwendig.

Aufgrund der reversiblen Aufnahme der Modul-Leiterplatte kann die Modul-Leiterplatte durch eine andere Modul-Leiterplatte leicht ausgetauscht bzw. ersetzt werden.

Das Leiterplattenmodulgehäuse ist vorzugsweise aus einem Isolierstoff gefertigt. Vorzugsweise weist das Leiterplattenmodulgehäuse einen elektrisch isolierenden Kunststoff oder eine elektrisch isolierende Keramik auf.

Die Aufnahme des Leiterplattenmodulgehäuses ist vorzugsweise als Aufnahmeraum im Leiterplattenmodulgehäuse ausgebildet. Weiter vorzugsweise ist in der Aufnahme eine Führungs- und/oder Positionierungseinrichtung angeordnet, mittels der eine Modul-Leiterplatte in der Aufnahme geführt und/oder positioniert wird.

Der Spannungseingangsanschluss des Leiterplattenmodulgehäuses kann auch als Stromeingangsanschluss bezeichnet werden. Die Spannungskontaktierungseinrichtung kann auch als Stromkontaktierungseinrichtung bezeichnet werden.

Die Modul-Leiterplatte ist vorzugsweise mit elektrisch leitenden Kontaktierungspads ausgebildet, die derart positioniert sind, dass bei bestimmungsgemäßem Einsetzen der Modul-Leiterplatte die Kontaktierungspads mit der Spannungskontaktierungseinrichtung und mit der Signalleitungskontaktierung in elektrischen Kontakt stehen.

Vorzugsweise ist der modulare Steckverbinder derart ausgebildet, dass die zumindest eine Anschlussklemme mit der Signalleitungskontaktierung elektrisch verbunden ist, so dass ein Datenaustausch zwischen der Anschlussklemme und der Modul-Leiterplatte ermöglicht ist.

Der Datenaustausch ist von der Anschlussklemme zur Modul-Leiterplatte und/oder von der Modul-Leiterplatte zur Anschlussklemme ermöglicht.

Vorzugsweise ist der modulare Steckverbinder derart ausgebildet, dass das Leiterplattenmodulgehäuse eine in der Aufnahme angeordnete Aufnahmeführung aufweist, so dass die Modul-Leiterplatte zwischen einerseits der Aufnahmeführung und andererseits Spannungsversorgungskontaktierung und der Signalleitungskontaktierung einsetzbar ist.

Durch eine entsprechende Ausführung des modularen Steckverbinders ist eine bestimmungsgemäße Positionierung der Modul-Leiterplatte und eine zuverlässige elektrische Kontaktierung der Spannungsversorgungskontaktierung und der Signalleitungskontaktierung durch die Modul-Leiterplatte gewährleistet.

Die Aufnahmeführung ist vorzugsweise als eine Führungsleiste, weiter vorzugsweise als zwei Führungsleisten ausgebildet. Die Führungsleisten sind vorzugsweise an Seitenwänden des Leiterplattenmodulgehäuses ausgebildet und ragen in einen Aufnahmeraum der Aufnahme hinein.

Vorzugsweise ist der modulare Steckverbinder derart ausgebildet, dass die Spannungsversorgungskontaktierung federkraftbeaufschlagt ist, so dass eine zwischen der Aufnahmeführung und der Spannungsversorgungskontaktierung positionierte Modul-Leiterplatte mittels der Spannungsversorgungskontaktierung in Richtung der Aufnahmeführung kraftbeaufschlagt ist.

Durch eine entsprechende Ausführung des modularen Steckverbinders ist eine zuverlässige elektrische Kontaktierung der Spannungsversorgungskontaktierung durch die Modul-Leiterplatte gewährleistet.

Vorzugsweise ist der modulare Steckverbinder derart ausgebildet, dass die Signalleitungskontaktierung federkraftbeaufschlagt ist, so dass eine zwischen der Aufnahmeführung und der Signalleitungskontaktierung positionierte Modul-Leiterplatte mittels der Signalleitungskontaktierung in Richtung der Aufnahmeführung kraftbeaufschlagt ist.

Durch eine entsprechende Ausführung des modularen Steckverbinders ist eine zuverlässige elektrische Kontaktierung der Signalleitungskontaktierung durch die Modul-Leiterplatte gewährleistet.

Vorzugsweise ist der modulare Steckverbinder derart ausgebildet, dass das Leiterplattenmodulgehäuse einen Deckel aufweist, der zwischen einer Offenstellung, in der die Aufnahme zugänglich ist, und einer Schließstellung, in der die Aufnahme mittels des Deckels verschlossen ist, beweglich ist.

Durch eine entsprechende Ausbildung des modularen Steckverbinders ist die Aufnahme und damit die in der Aufnahme positionierte Modul-Leiterplatte vor ungewünschten Berührungen und vor Verschmutzung geschützt.

Vorzugsweise ist der modulare Steckverbinder derart ausgebildet, dass der Deckel Metall aufweist, so dass die Aufnahme bei sich in dessen Schließstellung befindlichem Deckel mittels des Deckels vor elektromagnetischer Strahlung geschützt ist.

Durch eine entsprechende Ausbildung des modularen Steckverbinders ist die Aufnahme und damit die in der Aufnahme positionierte Modul-Leiterplatte verbessert vor elektromagnetischer Strahlung geschützt.

Vorzugsweise besteht der Deckel aus einem Metall. Weiter vorzugsweise ist eine Metallschicht in dem Deckel eingebettet, so dass die Außenschichten des Deckels aus einem Isolierstoff (z.B. Kunststoff oder Keramik) bestehen und zwischen den Außenschichten eine Metallschicht angeordnet ist.

Vorzugsweise ist der modulare Steckverbinder derart ausgebildet, dass das Leiterplattenmodulgehäuse Metall aufweist, so dass die Aufnahme mittels des Leiterplattenmodulgehäuses vor elektromagnetischer Strahlung geschützt ist.

Durch eine entsprechende Ausbildung des modularen Steckverbinders ist die Aufnahme und damit die in der Aufnahme positionierte Modul-Leiterplatte verbessert vor elektromagnetischer Strahlung geschützt.

Vorzugsweise besteht das Leiterplattenmodulgehäuse aus einem Metall. Weiter vorzugsweise ist eine Metallschicht in dem Leiterplattenmodulgehäuse eingebettet, so dass die Außenschichten des Leiterplattenmodulgehäuses aus einem Isolierstoff (z.B. Kunststoff oder Keramik) bestehen und zwischen den Außenschichten eine Metallschicht angeordnet ist.

Vorzugsweise ist der modulare Steckverbinder derart ausgebildet, dass der modulare Steckverbinder als Leiterplattenklemme ausgebildet ist und der Spannungseingangsanschluss an einer Unterseite des Leiterplattenmodulgehäuses angeordnet ist.

Weitere Vorteile, Einzelheiten und Merkmale der Erfindung ergeben sich nachfolgend aus den erläuterten Ausführungsbeispielen. Dabei zeigen im Einzelnen:
- Figur 1:: eine perspektivische Darstellung eines erfindungsgemäßen modularen Steckverbinders mit demontiertem Deckel und ausgebauter Modul-Leiterplatte;
- Figur 2:: eine perspektivische Darstellung des in Figur 1 dargestellten modularen Steckverbinders mit montiertem Deckel;
- Figur 3:: eine perspektivische Darstellung einer Rückseite des in Figur 2 dargestellten modularen Steckverbinders; und
- Figur 4:: eine perspektivische Darstellung eines als Leiterplattenklemme ausgebildeten modularen Steckverbinders.

In der nun folgenden Beschreibung bezeichnen gleiche Bezugszeichen gleiche Bauteile beziehungsweise gleiche Merkmale, so dass eine in Bezug auf eine Figur durchgeführte Beschreibung bezüglich eines Bauteils auch für die anderen Figuren gilt, so dass eine wiederholende Beschreibung vermieden wird. Ferner sind einzelne Merkmale, die in Zusammenhang mit einer Ausführungsform beschrieben wurden, auch separat in anderen Ausführungsformen verwendbar.

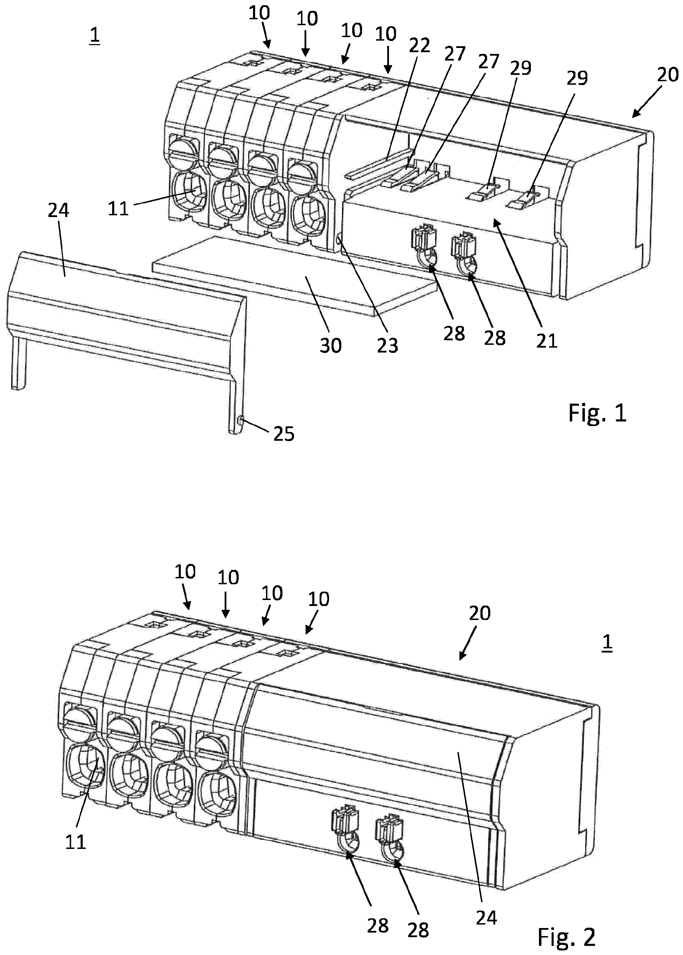

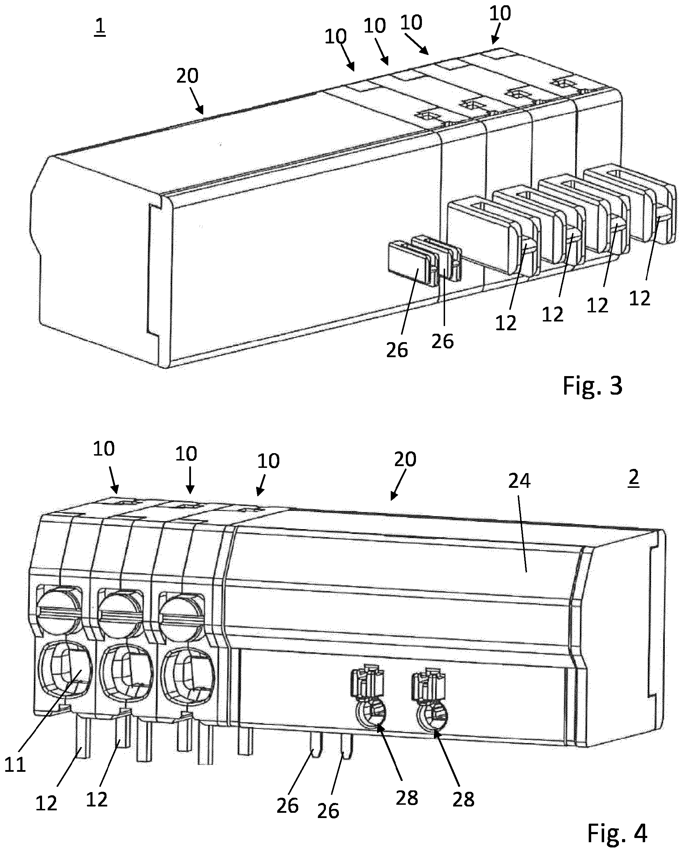

Figur 1 zeigt eine perspektivische Darstellung eines erfindungsgemäßen modularen Steckverbinders 1 mit demontiertem Deckel 24 und ausgebauter Modul-Leiterplatte 30. Der modulare Steckverbinder 1 weist zumindest eine Anschlussklemme 10 und ein Leiterplattenmodulgehäuse 20 auf. Bei dem in Figur 1 dargestellten Ausführungsbeispiel weist der modulare Steckverbinder 1 vier zueinander benachbarte und miteinander verbundene Anschlussklemmen 10 auf. Jede der Anschlussklemmen 10 weist jeweils einen Eingangsanschluss 11 und einen in Figur 3 dargestellten Ausgangsanschluss 12 auf. Die Eingangsanschlüsse 11 sind jeweils an einer Vorderseite des modularen Steckverbinders 1 und die Ausgangsanschlüsse 12 sind jeweils an einer Rückseite des modularen Steckverbinders 1 angeordnet.

Aus Figur 1 ist ersichtlich, dass das Leiterplattenmodulgehäuse 20, das mit der in Figur 1 links benachbarten Anschlussklemme 10 verbunden ist, eine Aufnahme 21 aufweist. Die Aufnahme 21 ist als Aufnahmeraum 21 ausgebildet. Die Aufnahme 21 dient zum reversiblen Einsetzen einer Modul-Leiterplatte 30. Folglich kann eine Modul-Leiterplatte 30 durch eine andere Modul-Leiterplatte 30 ausgetaucht werden.

In der Aufnahme 21 ist eine Spannungsversorgungskontaktierung 27 angeordnet, die mit einem in Figur 3 dargestellten Spannungseingangsanschluss 26 des Leiterplattenmodulgehäuses 20 elektrisch verbunden ist. Der Spannungseingangsanschluss 26 ist an der Rückseite des Leiterplattenmodulgehäuses 20 angeordnet. Somit kann eine in der Aufnahme 21 eingesetzte Modul-Leiterplatte 30 mittels der Spannungsversorgungskontaktierung 27 durch den Spannungseingangsanschluss 26 mit elektrischer Energie versorgt werden.

In der Aufnahme 21 sind ferner zwei Signalleitungskontaktierungen 29 angeordnet, die mit zwei Signalleitungsanschlüssen 28 des Leiterplattenmodulgehäuses 20 elektrisch verbunden sind. Die Signalleitungsanschlüsse 28 sind an der Vorderseite des Leiterplattenmodulgehäuses 20 angeordnet. Somit kann eine in der Aufnahme 21 eingesetzte Modul-Leiterplatte 30 mittels den Signalleitungskontaktierungen 29 und den Signalleitungsanschlüssen 28 mit anderen elektrischen und/oder elektronischen Gerätschaften, die in den Figuren nicht dargestellt sind, Daten und/oder Signal austauschen.

Die Signalleitungskontaktierungen 29 sind ferner vorzugsweise mit einer oder mit mehreren der Anschlussklemmen 10 elektrisch verbunden, sodass auch ein Datenaustausch zwischen der Anschlussklemme 10 bzw. den Anschlussklemmen 10 und der Modul-Leiterplatte 30 ermöglicht ist. Beispielsweise lässt sich mittels der Modul-Leiterplatte 30 ein durch eine Anschlussklemme 10 fließender elektrischer Strom bestimmen. Ferner können bei einer entsprechenden in den Anschlussklemmen 10 bereitgestellten Sensorik beispielsweise die Temperatur in den Anschlussklemmen 10 bestimmt werden und mittels der Modul-Leiterplatte 30 an eine weitere elektronische Gerätschaft weitergeleitet werden.

Aus Figur 1 ist ersichtlich, dass in der Aufnahme 21 des Leiterplattenmodulgehäuses 20 eine Aufnahmeführung 22 angeordnet ist. Die Aufnahmeführung 22 ist dabei in Form von Führungsleisten 22 ausgebildet. Eine Führungsleiste ist an einer Innenseite einer Seitenwand des Leiterplattenmodulgehäuses 20 und eine weiter Führungsleiste der Aufnahmeführung 22 ist an einer Innenseite einer gegenüberliegenden Seitenwand des Leiterplattenmodulgehäuses angeordnet.

Die Modul-Leiterplatte 30 ist zwischen die Aufnahmeführung 22 einerseits und die Spannungsversorgungskontaktierung 27 und die Signalleitungskontaktierungen 29 andererseits einsetzbar bzw. einschiebbar. Sowohl die Spannungsversorgungskontaktierung 27 als auch die Signalleitungskontaktierungen 29 sind federkraftbeaufschlagt, sodass eine zwischen der Aufnahmeführung 22 und der Spannungsversorgungskontaktierung 27 und der Signalleitungskontaktierungen 29 positionierte Modul-Leiterplatte 30 mittels der Spannungsversorgungskontaktierung 27 und der Signalleitungskontaktierung 29 in Richtung der Aufnahmeführung 22 kraftbeaufschlagt wird. Somit ist eine zuverlässige elektrische Kontaktierung der Modul-Leiterplatte 30 mittels der Spannungsversorgungskontaktierung 27 und der Signalleitungskontaktierung 29 gewährleistet.

Obschon aus Figur 1 nicht ersichtlich, sind an entsprechenden Stellen der Modul-Leiterplatte 30 elektrische Kontaktierungseinrichtungen in Form von Kontaktierungspads angeordnet, die mit der Spannungsversorgungskontaktierung 27 und den Signalleitungskontaktierungen 29 bei bestimmungsgemäß eingesetzter Modul-Leiterplatte 30 in der Aufnahme 21 mit diesen in elektrischen Kontakt stehen.

Der erfindungsgemäße modulare Steckverbinder 1 weist ferner einen Deckel 24 auf, der zwischen einer Offenstellung, in der die Aufnahme 21 zugänglich ist, und einer in Figur 2 dargestellten Schließstellung, in der die Aufnahme 21 mittels des Deckels 24 verschlossen ist, beweglich ist. Der Deckel 24 weist dazu zwei Lagerzapfen 25 auf, die in entsprechende Lageröffnungen 23 des Leiterplattenmodulgehäuses 20 eingesetzt sind, sodass der Deckel 24 schwenkbar gelagert ist.

Der Deckel 24 ist vorzugsweise aus einem elektrisch isolierenden Material, so wie beispielsweise einem Kunststoff oder einer elektrisch isolierenden Keramik gebildet. Vorzugsweise ist in dem Deckel 24 eine Metallschicht vorgesehen, sodass die Aufnahme 21 mittels des Deckels 24 vor elektromagnetischer Strahlung geschützt ist.

Zu diesem Zweck kann auch das Leiterplattenmodulgehäuse 20 eine Metallschicht aufweisen, sodass die Aufnahme 21 auch mittels des Leiterplattenmodulgehäuses 20 vor elektromagnetischer Strahlung geschützt ist.

In Figur 4 ist ein modularer Steckverbinder 2 dargestellt, der als Leiterplattenklemme 2 ausgebildet ist. Die Leiterplattenklemme 2 unterscheidet sich von dem in Figur 1 dargestellten modularen Steckverbinder 1 dadurch, dass die Ausgangsanschlüsse 12 der Anschlussklemmen 10 und auch die Spannungseingangsanschlüsse 26 des Leiterplattenmodulgehäuses 20 an einer Unterseite der Leiterplattenklemme 2 angeordnete sind, sodass diese in entsprechende Öffnungen in einer Leiterplatte eingesetzt werden können und mit diesem beispielsweise über eine Verlötung elektrisch kontaktiert werden können. Der übrige Aufbau der in Figur 4 dargestellten Leiterplattenklemme 2 ist identisch mit dem Aufbau des in den Figuren 1 bis 3 dargestellten modularen Steckverbinders 1.

### Bezugszeichenliste

- 1: modularer Steckverbinder
- 2: Leiterplattenklemme
- 10: Anschlussklemme
- 11: Eingangsanschluss (der Anschlussklemme)
- 12: Ausgangsanschluss (der Anschlussklemme)
- 20: Leiterplattenmodulgehäuse
- 21: Aufnahme (des Leiterplattenmodulgehäuses)
- 22: Aufnahmeführung
- 23: Lageröffnung (des Leiterplattenmodulgehäuses)
- 24: Deckel (des Leiterplattenmodulgehäuses)
- 25: Lagerzapfen (des Deckels)
- 26: Spannungseingangsanschluss / Stromeingangsanschluss (des Leiterplattenmodulgehäuses)
- 27: Spannungsversorgungskontaktierung / Stromversorgungskontaktierung
- 28: Signalleitungsanschluss (des Leiterplattenmodulgehäuses)
- 29: Signalleitungskontaktierung
- 30: Modul-Leiterplatte

## Patentansprüche

1. Modularer Steckverbinder (1, 2), die folgenden Merkmale aufweisend:
- der modulare Steckverbinder (1, 2) weist zumindest eine Anschlussklemme (10) und ein Leiterplattenmodulgehäuse (20) auf, das mit der Anschlussklemme (10) verbunden ist;
- das Leiterplattenmodulgehäuse (20) weist eine Aufnahme (21) zum reversiblen Einsetzen einer Modul-Leiterplatte (30) auf;
- das Leiterplattenmodulgehäuse (20) weist einen Spannungseingangsanschluss (26) zur Verbindung mit einer Spannungsquelle und eine mit dem Spannungseingangsanschluss (26) elektrisch verbundene Spannungsversorgungskontaktierung (27) auf;
- eine in der Aufnahme (21) eingesetzte Modul-Leiterplatte (30) ist mittels der Spannungsversorgungskontaktierung (27) durch den Spannungseingangsanschluss (26) mit elektrischer Energie versorgbar; und
- das Leiterplattenmodulgehäuse (20) weist einen Signalleitungsanschluss (28) und eine mit dem Signalleitungsanschluss (28) elektrisch verbundene Signalleitungskontaktierung (29) auf, so dass ein Datenaustausch zwischen dem Signalleitungsanschluss (28) und der in die Aufnahme eingesetzte Modul-Leiterplatte (30) über die Signalleitungskontaktierung (29) ermöglicht ist.

2. Modularer Steckverbinder (1, 2) nach Anspruch 1, **dadurch gekennzeichnet, dass** die zumindest eine Anschlussklemme (10) mit der Signalleitungskontaktierung (29) elektrisch verbunden ist, so dass ein Datenaustausch zwischen der Anschlussklemme (10) und der Modul-Leiterplatte (30) ermöglicht ist.

3. Modularer Steckverbinder (1, 2) nach einem der vorhergehenden Ansprüche, **dadurch gekennzeichnet, dass** das Leiterplattenmodulgehäuse (20) eine in der Aufnahme (21) angeordnete Aufnahmeführung (22) aufweist, so dass die Modul-Leiterplatte (30) zwischen einerseits der Aufnahmeführung (22) und andererseits Spannungsversorgungskontaktierung (27) und der Signalleitungskontaktierung (29) einsetzbar ist.

4. Modularer Steckverbinder (1, 2) nach Anspruch 3, **dadurch gekennzeichnet, dass** die Spannungsversorgungskontaktierung (27) federkraftbeaufschlagt ist, so dass eine zwischen der Aufnahmeführung (22) und der Spannungsversorgungskontaktierung (27) positionierte Modul-Leiterplatte (30) mittels der Spannungsversorgungskontaktierung (27) in Richtung der Aufnahmeführung (22) kraftbeaufschlagt ist.

5. Modularer Steckverbinder (1, 2) nach Anspruch 3 oder 4, **dadurch gekennzeichnet, dass** die Signalleitungskontaktierung (29) federkraftbeaufschlagt ist, so dass eine zwischen der Aufnahmeführung (22) und der Signalleitungskontaktierung (29) positionierte Modul-Leiterplatte (30) mittels der Signalleitungskontaktierung (29) in Richtung der Aufnahmeführung (22) kraftbeaufschlagt ist.

6. Modularer Steckverbinder (1, 2) nach einem der vorhergehenden Ansprüche, **dadurch gekennzeichnet, dass** Leiterplattenmodulgehäuse (20) einen Deckel (24) aufweist, der zwischen einer Offenstellung, in der die Aufnahme (21) zugänglich ist, und einer Schließstellung, in der die Aufnahme (21) mittels des Deckels (24) verschlossen ist, beweglich ist.

7. Modularer Steckverbinder (1, 2) nach Anspruch 6, **dadurch gekennzeichnet, dass** der Deckel (24) Metall aufweist, so dass die Aufnahme (21) bei sich in dessen Schließstellung befindlichem Deckel (24) mittels des Deckels (24) vor elektromagnetischer Strahlung geschützt ist.

8. Modularer Steckverbinder (1, 2) nach einem der vorhergehenden Ansprüche, **dadurch gekennzeichnet, dass** das Leiterplattenmodulgehäuse (20) Metall aufweist, so dass die Aufnahme (21) mittels des Leiterplattenmodulgehäuses (20) vor elektromagnetischer Strahlung geschützt ist.

9. Modularer Steckverbinder (1, 2) nach einem der vorhergehenden Ansprüchen, **dadurch gekennzeichnet, dass** der modulare Steckverbinder (1, 2) als Leiterplattenklemme (2) ausgebildet ist und der Spannungseingangsanschluss (26) an einer Unterseite (3) des Leiterplattenmodulgehäuses (2) angeordnet ist.
